(19) Europäisches Patentamt

European Patent Office

Office européen des brevets

(11) EP 0 877 484 B1

(12) FASCICULE DE BREVET EUROPEEN

(45) Date de publication et mention
de la délivrance du brevet:
**20.02.2002 Bulletin 2002/08**

(51) Int Cl.⁷: **H03K 5/26**, B61L 1/20

(21) Numéro de dépôt: **98401082.7**

(22) Date de dépôt: **04.05.1998**

(54) **Dispositif de validation de messages numériques, applicable notamment aux systèmes de régulation du trafic ferroviaire**

Freigabevorrichtung für numerische Botschaft, insbesondere anwendbar in Schienenverkehrsregalsystemen

Enabling device for a numerical message, especially for use in railway control systems

(84) Etats contractants désignés:
**AT BE CH CY DE DK ES FI GB GR IE IT LI LU MC NL PT SE**
Etats d'extension désignés:
**LT LV RO SI**

(30) Priorité: **07.05.1997 FR 9705661**

(43) Date de publication de la demande:
**11.11.1998 Bulletin 1998/46**

(73) Titulaire: **CSEE Transport
91944 Les Ulis Cédex (FR)**

(72) Inventeur: **Demarais, Gérard
77310 Saint Fargeau (FR)**

(74) Mandataire: **Chameroy, Claude et al
c/o Cabinet Malémont 42, avenue du Président Wilson
75116 Paris (FR)**

(56) Documents cités:
**WO-A-83/02816       WO-A-96/33086
GB-A- 1 354 941       US-A- 4 816 960**

**Description**

La présente invention concerne un dispositif de validation de messages numériques, du type dans lequel on contrôle l'identité absolue et l'état dynamique de deux messages numériques issus de deux voies de traitement en parallèle, avant d'élaborer, au moyen d'un amplificateur de sortie, un signal analogique tout ou rien de sécurité assurant le fonctionnement d'un actionneur. Un tel dispositif est décrit dans le brevet US 4 816 960.

Dans tout système d'exploitation pouvant, suite à des défaillances - fussent-elles seulement hypothétiques - engager la sécurité des personnes prises en charge par ce système, il y a nécessité impérieuse d'organiser le système afin qu'il puisse garantir, quelles que soient les perturbations ou dégradations envisagées, l'impossibilité absolue de situations dangereuses, aussi bien pour les personnes que pour les matériels contrôlés par ce système.

Pour cela, les automatismes correspondants sont conçus et organisés de telle sorte que toute défaillance place impérativement le système, soit dans un état de fonctionnement plus restrictif (ralentissement, voire arrêt d'un mobile par exemple), soit dans un état de sécurité absolue (coupure de l'énergie par exemple).

Si le concept de sécurité intrinsèque ("fail safe"), largement utilisé dans le domaine du transport ferroviaire ne recourt qu'à une seule voie de traitement, il ne peut en être de même des automatismes basés sur une gestion numérique qui ne pourraient, alors, garantir qu'une sécurité élevée certes, mais probabiliste et non absolue.

Cependant, la puissance d'interprétation et de gestion des systèmes numériques est telle que l'on choisit cette solution de plus en plus fréquemment, bien que ce choix impose de recourir à deux voies de traitement en parallèle, dont on exige des résultats rigoureusement identiques.

A cette fin, on utilise un circuit établi en sécurité intrinsèque qui constitue l'organe décideur ou de validation et réalise la fonction d'intersection faisant converger les résultats des deux voies de traitement numérique. Après contrôle de l'identité absolue et de l'état dynamique des deux messages binaires issus des voies de traitement numérique, ce circuit de validation décide d'émettre vers le ou les actionneurs du système, les ordres tout ou rien correspondants.

On notera dès maintenant que ces messages sont récurrents. Autrement dit, chacun d'entre eux est constitué d'une séquence de plusieurs octets émis en série et de manière continue, "bit à bit". De plus, le logiciel des voies de traitement numérique est organisé de manière que les messages émis ne comportent jamais plus de quelques bits successifs, par exemple trois, à la même valeur binaire, ce qui permet de contrôler leur état dynamique. Ainsi, dans le cas où il y a un "figeage", simultané ou non, des messages émis par les deux voies de traitement, le système doit se déclarer en défaut en repassant automatiquement à l'état sécuritaire.

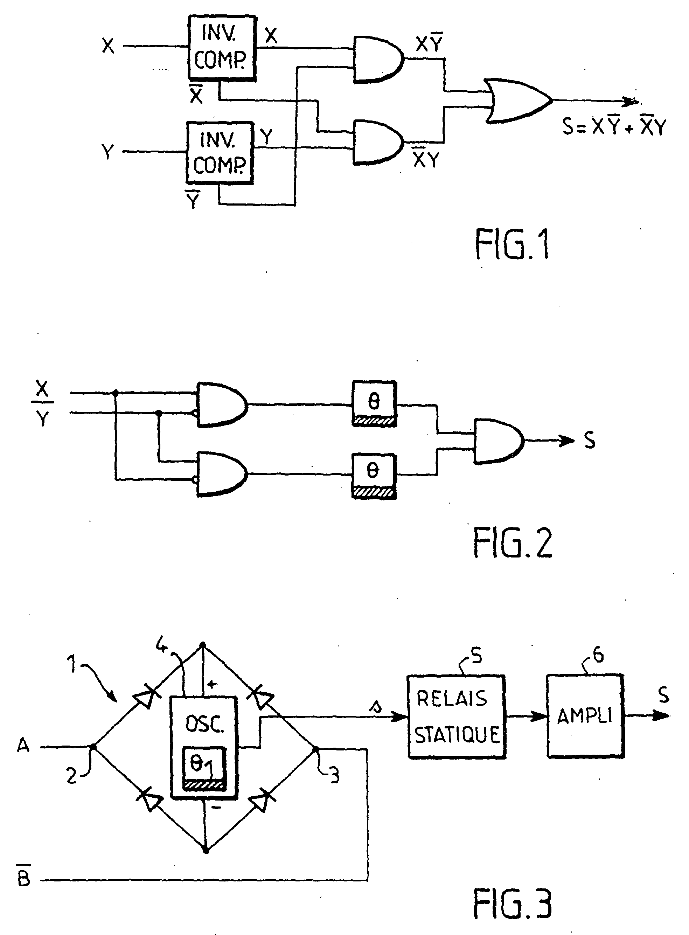

Dans l'état actuel de la technique, la première des deux fonctions de validation, à savoir le contrôle d'identité des messages, nécessite un circuit du genre de celui représenté sur la figure 1, comportant, pour les deux messages X et Y, au moins deux inverseurs complémentaires, deux portes logiques ET et une porte logique OU. Quant à la deuxième fonction de validation, à savoir le contrôle dynamique des messages, elle nécessite un circuit du genre de celui représenté sur la figure 2 comportant au moins trois portes logiques ET et deux temporisations à la chute.

De tels circuits sont apparemment très simples, mais lorsqu'ils sont réalisés en sécurité intrinsèque, ils requièrent un nombre très élevé de composants, d'où un encombrement également très important, notamment en surface de circuit imprimé.

La présente invention a donc pour but principal de remédier à cet inconvénient et pour ce faire, elle a pour objet un dispositif de validation de messages numériques du type susmentionné qui se caractérise essentiellement en ce qu'il comprend un pont de Wheatstone à diodes dont les entrées alternatives sont alimentées respectivement par les deux messages, préalablement inversés l'un par rapport à l'autre, et dont la diagonale continue comporte un oscillateur dont la sortie constitue le signal de contrôle d'identité des messages, ce signal commandant l'amplificateur de sortie par l'intermédiaire d'un relais statique.

Ainsi, l'oscillateur ne peut fonctionner que si les deux messages numériques sont parfaitement identiques, ou plus précisément complémentaires, et ce bit par bit, ce qui procure une sécurité absolue.

Le dispositif selon l'invention comprend en outre deux commandes perdues alimentées respectivement par les deux messages numériques et fonctionnant sur les transitions des changements d'état des messages, ces deux commandes perdues fournissant, par l'intermédiaire d'une porte OU, la tension nécessaire à l'alimentation du relais statique.

Ainsi, le relais statique ne peut commander le fonctionnement de l'amplificateur de sortie que si les deux messages numériques issus des voies de traitement sont à la fois identiques et non "figés". Il assure donc de façon particulièrement commode la fonction d'intersection des deux contrôles, à savoir le contrôle d'identité et le contrôle de l'état dynamique des deux messages.

On notera par ailleurs que, selon l'invention, ces deux fonctions de contrôle peuvent être réalisées sur une surface de circuit imprimé qui est de plusieurs centaines de fois inférieure à ce qu'elle est dans la technique antérieure, et ce en toute sécurité.

Le dispositif selon l'invention comprend également un système d'armement comportant deux autres commandes perdues, l'une alimentée par un signal de commande d'armement issu des voies de traitement numérique et l'autre par un signal d'auto-maintien issu de l'amplificateur de sortie, ces deux commandes perdues fournissant, par l'intermédiaire d'une porte OU, la tension d'alimentation nécessaire au fonctionnement de l'oscillateur.

On obtient ainsi une structure pyramidale dans laquelle chaque étage tire son énergie de l'étage précédent, ce qui exclut toute réalimentation accidentelle d'un circuit stratégique par un signal parasite ou l'alimentation du réseau.

De préférence, l'oscillateur du pont de Wheatstone est pourvu d'une temporisation à la chute, ce qui permet d'accepter une légère désynchronisation entre les deux messages numériques.

De préférence également, les deux premières commandes perdues sont connectées aux entrées alternatives du pont de Wheatstone, ce qui constitue un contrôle supplémentaire du niveau des signaux sur ces entrées.

D'autres caractéristiques et avantages ressortiront mieux de la description qui va suivre d'un mode de réalisation de l'invention, donné à titre d'exemple non limitatif en référence aux dessins annexés dans lesquels :

- la figure 1, déjà mentionnée, est un schéma d'un circuit classique permettant d'effectuer le contrôle d'identité de deux messages numériques,
- la figure 2, également déjà mentionnée, est un schéma d'un circuit classique permettant d'effectuer le contrôle de l'état dynamique des deux messages,
- la figure 3 est un schéma simplifié d'un circuit conforme à l'invention permettant d'effectuer le contrôle d'identité des messages,
- la figure 4 est un schéma synoptique simplifié d'un circuit conforme à l'invention permettant d'effectuer le contrôle de l'état dynamique des messages,
- la figure 5 est un schéma d'un circuit illustrant le principe de la commande perdue,
- la figure 6 est un diagramme de signaux explicitant le fonctionnement du circuit représenté sur la figure 4,
- la figure 7 est un schéma du circuit complet du dispositif de validation conforme à l'invention, et
- la figure 8 est un diagramme de signaux explicitant le fonctionnement de ce circuit.

Le schéma de la figure 3 montre un circuit conforme à l'invention permettant de contrôler l'identité de deux messages numériques A et B issus de deux voies de traitement en parallèle non représentées. Ce circuit est essentiellement constitué d'un pont de Wheatstone à diodes 1 dont les entrées alternatives 2 et 3 sont alimentées respectivement par le message A et par le message B préalablement inversé par un moyen quelconque $\bar{B}$. Dans la diagonale continue de ce pont de Wheatstone 1 est connecté un oscillateur 4 dont le signal de sortie s commande, par l'intermédiaire d'un relais statique 5, le fonctionnement d'un amplificateur de sortie 6.

Grâce à cette disposition, l'oscillateur 4 ne peut fonctionner et donc émettre un signal de sortie s vers le relais statique 5 que si les deux messages numériques A et B sont parfaitement identiques, ou plus précisément si les niveaux des deux messages A et $\bar{B}$ sont en parfaite opposition, bit par bit. Le relais statique 5 assure donc le fonctionnement de l'amplificateur 6 qui émet alors à sa sortie un signal analogique de sécurité tout ou rien S vers un ou plusieurs actionneurs non représentés, constituées par exemple, dans le cas d'un système de régulation du trafic ferroviaire, par des relais de sécurité assurant le fonctionnement de feux de signalisation.

L'oscillateur 4, d'un type connu en soi, est avantageusement du type numérique et sera par exemple constitué par un circuit RC associé à un groupe d'inverseurs. De plus, cet oscillateur est équipé d'une temporisation à la chute $\theta_1$ permettant de boucher les trous lors des changements binaires de valeur des bits constituant les messages A et B, ce qui autorise une légère désynchronisation ou macrosynchronisation entre les deux messages. On garantit ainsi une disponibilité raisonnable du dispositif, sans avoir recours à une horloge synchrone commune aux deux voies de traitement numérique, avec le risque d'un mode commun susceptible d'engendrer, sous l'action d'un signal parasite, des codes identiques indus sur les deux voies.

On notera par ailleurs qu'un tel circuit de contrôle d'identité peut être réalisé sur une surface de circuit imprimé qui est environ 900 fois plus petite que celle occupée par un circuit classique en sécurité intrinsèque. Ceci permet avantageusement de monter plusieurs commandes d'actionneurs sur une même carte de circuit imprimé de format normalisé.

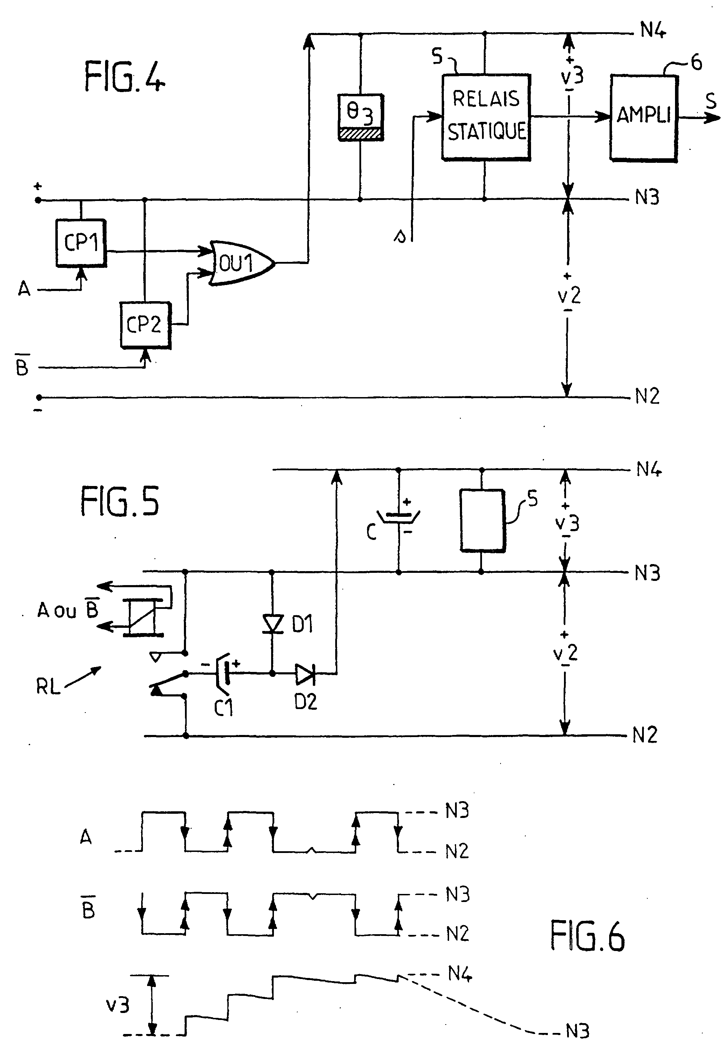

En se référant maintenant à la figure 4, on peut voir un circuit conforme à l'invention pour le contrôle de l'état dynamique des messages A et B. Ce circuit est essentiellement constitué par deux commandes perdues CP1 et CP2, également communément désignées sous le nom de pompes à diodes, alimentées respectivement par les deux messages numériques A et B ou A et $\bar{B}$. De préférence, les deux commandes perdues seront connectées directement aux entrées alternatives 2 et 3 du pont de Wheatstone 1, et donc alimentées par A et $\bar{B}$, procurant ainsi un contrôle supplémentaire du niveau des signaux sur ces entrées.

Les commandes perdues CP1 et CP2 utilisent les transitions correspondant au changement d'état des messages A et B et sont associées à une porte OU1 fournissant, à partir d'une tension v2, la tension v3 nécessaire à l'alimentation du relais statique 5, comme on le verra plus clairement par la suite. Une temporisation à la chute θ3 est en outre prévue sur la tension v3, cette temporisation permettant de régler le temps acceptable de non dynamisation des deux messages numériques A et B, avant que ne se déclenche l'arrêt du dispositif de validation et la chute de l'information sécuritaire S vers les actionneurs, par l'intermédiaire du relais statique 5 commandant l'amplificateur de sortie 6. Le relais statique 5 réalise donc la fonction d'intersection des deux contrôles - identité et état dynamique des messages A et B - et ne peut commander le fonctionnement de l'amplificateur de sortie 6 que si ces deux messages sont simultanément identiques (ou plus précisément complémentaires) et non "figés".

Le principe de fonctionnement d'une commande perdue va maintenant être explicité en se référant aux figures 5 et 6. Sur le schéma de la figure 5 on trouve tout d'abord un relais RL commandé par le message A ou B et qui est connecté aux bornes de la tension v2. On notera toutefois dès maintenant que dans la réalité le rôle du relais RL est tenu par un inverseur statique qui sera décrit plus en détail par la suite. Au point milieu de ce relais RL est connecté un condensateur C1 qui se trouve relié, par des diodes en opposition D1 et D2, respectivement au + de v2 et au + de v3. Aux bornes de la tension v3 est connecté un condensateur de filtrage C, en parallèle sur le circuit d'utilisation constitué ici par le relais statique 5.

Ainsi, les transitions négatives des messages A ou $\bar{B}$, représentées sur la figure 6 par une seule flèche, "arment" la commande perdue, c'est-à-dire qu'elles chargent le condensateur C1 par l'intermédiaire de la diode D1. Quant aux transitions positives des messages A ou $\bar{B}$, représentées sur la figure 6 par deux flèches, elles font passer le - de C1 au + de v2, de sorte qu'il se produit un transfert d'énergie de C1 sur le condensateur de filtrage C par l'intermédiaire de la diode D2. La tension v3 nécessaire au fonctionnement du relais statique 5 se trouve ainsi progressivement élaborée aux bornes du condensateur de filtrage C, comme illustré sur le diagramme de la figure 6.

On notera ici que l'inversion de B par rapport à A présente l'avantage supplémentaire de permettre une recharge alternée de la tension v3 par les commandes perdues CP1 et CP2.

On voit donc en définitive que les commandes perdues CP1 et CP2 élaborent, à partir de la tension v2 utilisée comme source d'énergie, la tension v3 qui se situe potentiellement au-dessus de v2, puisque le - de v3 se trouve référencé au + de v2. on évite ainsi le risque de réalimentation accidentelle par fuite ou autre, d'un circuit sécuritaire par une quelconque alimentation de service, ce qui est un souci constant dans le domaine de l'électronique réalisée en sécurité intrinsèque. En effet, il existe tout d'abord une première possibilité de fuite entre le + de v3 et le - de v2, mais alors la tension sur le circuit d'utilisation 5 serait inversée et donc inopérante. Il existe également une seconde possibilité de fuite entre le + de v2 et le + de v3, mais alors la tension v3 aux bornes du circuit d'utilisation 5 deviendrait nulle et donc également inopérante. De plus, comme l'énergie de v3 procède de celle de v2, tout transfert d'énergie de v3 vers v2 est totalement impossible.

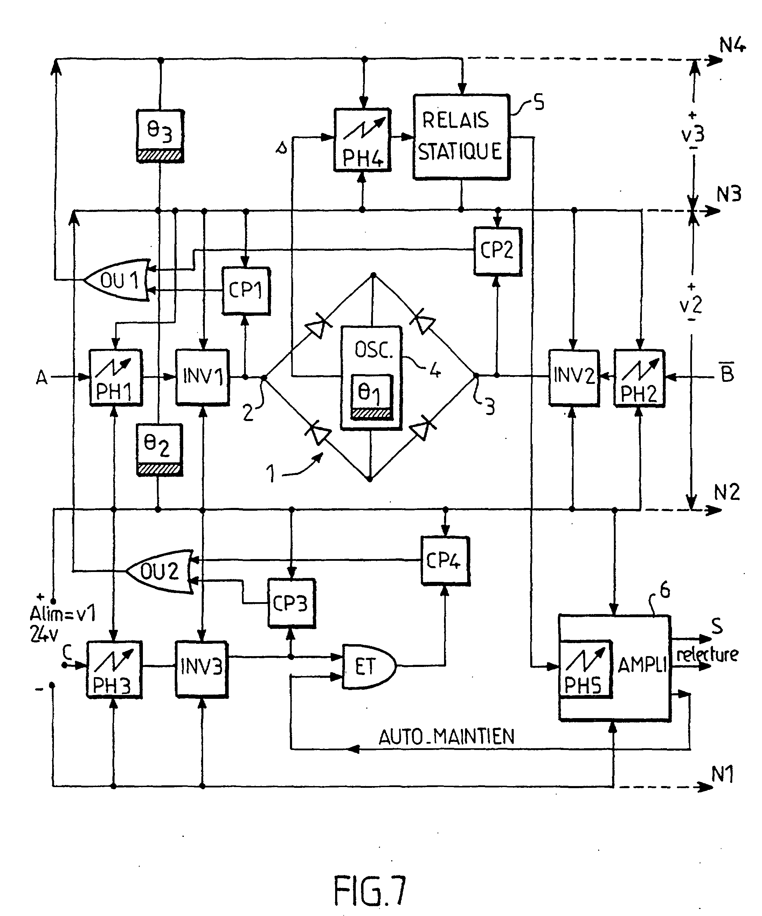

Le circuit complet du dispositif de validation selon l'invention est représenté sur la figure 7. Sur cette figure, on retrouve tout d'abord, le pont de Wheatstone 1, l'oscillateur 4 avec sa temporisation à la chute θ1, et le relais statique 5 commandant l'amplificateur de sortie 6. On y retrouve également les deux commandes perdues CP1 et CP2 associées à la porte OU1 et la temporisation à la chute θ3 branchée entre les niveaux N3 et N4 de la tension v3.

Les deux messages numériques A et $\bar{B}$ sont en fait appliqués aux entrées alternatives 2 et 3 du pont de Wheatstone 1 par l'intermédiaire de coupleurs photo-électriques, respectivement PH1 et PH2, et d'inverseurs statiques, respectivement INV1 et INV2, branchés entre les niveaux N2 et N3 de la tension v2. Les coupleurs photo-électriques réalisent un isolement galvanique des signaux, tandis que les inverseurs régénèrent le niveau des signaux. Ces derniers fonctionnent en réalité comme des amplificateurs de niveau tout ou rien en butée haute ou basse sur les niveaux N3 ou N2 de l'alimentation constituée par la tension v2, au rythme du signal d'entrée. Ils tiennent également le rôle du relais RL représenté sur la figure 5 pour les commandes perdues CP1 et CP2.

Conformément à l'invention, ce dispositif de validation est également équipé d'un système d'armement entièrement statique, essentiellement constitué par deux autres commandes perdues CP3 et CP4, associées à une porte OU2 dont la sortie est reliée au niveau N3 de la tension v2. Un signal de commande d'armement C, constitué par un signal long, alimente la commande perdue CP3 par l'intermédiaire d'un coupleur photo-électrique PH3 et d'un inverseur statique INV3, branchés entre les niveaux N1 et N2 de la tension v1, constitué par exemple par la tension d'alimentation 24V du réseau local. Quant à la commande perdue CP4, elle est alimentée à partir d'un signal d'auto-maintien issu de l'amplificateur de sortie 6, par l'intermédiaire d'une porte ET recevant sur son autre entrée le signal de commande d'armement C. On notera ici que l'amplificateur de sortie 6 comporte, outre la sortie du signal sécuritaire S, une troisième sortie isolée dite de relecture destinée aux deux voies de traitement numérique.

La tension v2 nécessaire au fonctionnement des commandes perdues CP1 et CP2 est ainsi élaborée par les commandes perdues CP3 et CP4 à partir de la tension v1 du réseau local. Une temporisation à la chute θ2 est en outre prévue sur la tension v2, afin de régler le temps nécessaire pour que l'énergie fournie par CP4 grâce au signal d'auto-maintien prenne le relais de l'énergie initiale fournie par CP3 grâce au signal de commande d'armement C.

On notera par ailleurs que dans la commande perdue CP3, la diode D1 de la figure 5 est remplacée par une simple résistance, ce qui permet de contrôler à volonté le temps choisi pour la commande d'armement. En effet, c'est alors la totalité du signal long d'armement C qui charge le condensateur C1 de la figure 5, et pas seulement son front négatif.

Il convient également de remarquer ici que les portes OU1 ou OU2 correspondent en fait simplement à la mise en parallèle des cathodes des diodes D2 représentées sur la figure 5.

On obtient donc en définitive une architecture pyramidale des différentes alimentations dans laquelle chaque étage tire son énergie de l'étage précédent, ce qui permet d'éviter toute réalimentation accidentelle d'un circuit stratégique. En effet, la tension v2, comprise entre les niveaux N2 et N3, tire son énergie de la tension v1, comprise entre les niveaux N1 et N2, qui est l'alimentation réseau et cela au moyen des commandes perdues CP3 et CP4 récapitulées par la porte OU2. Quant à la tension v3, comprise entre les niveaux N3 et N4, elle tire son énergie de la tension v2 au moyen des commandes perdues CP1 ET CP2 récapitulées par la porte OU1. Cette tension v3 constitue l'information sécuritaire utilisée par le relais statique 5 qu'elle contrôle "alimentairement", ce relais statique réalisant la fonction d'intersection des informations de contrôle de l'identité et de l'état dynamique des deux messages numériques A et B.

On notera enfin que le circuit représenté sur la figure 7 comprend également deux autres coupleurs photo-électriques PH4 et PH5, insérés respectivement entre l'oscillateur 4 et le relais statique 5 et entre ce relais statique et l'amplificateur de sortie 6. Ces coupleurs photo-électriques ont un rôle d'isolement électrique, entre v2 et v3 pour PH4 et entre v3 et v1 pour PH5. Des fuites entrée/sortie de ces photocoupleurs n'auraient d'autre incidence que de voir les niveaux N3 et N4 se rapprocher de N2, d'où une disparition progressive de v3, puis de v2, entraînant la chute du signal sécuritaire S vers les actionneurs.

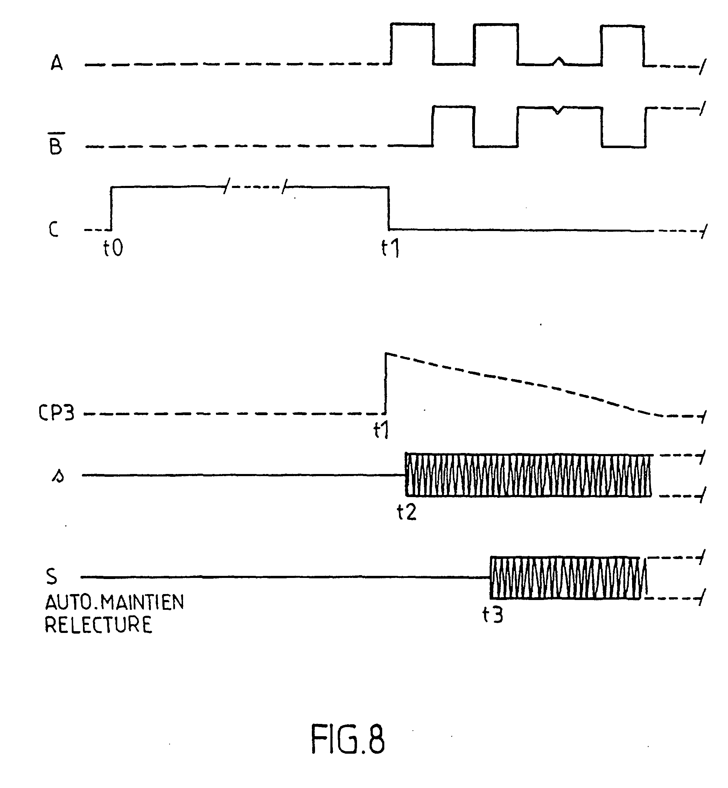

On va maintenant décrire un exemple de fonctionnement du dispositif de validation selon l'invention, en se référant plus particulièrement au diagramme de signaux de la figure 8 sur laquelle on retrouve, les deux messages numériques A et $\bar{B}$, le signal de commande d'armement C, l'énergie d'armement de la commande perdue CP3, le signal s issu de l'oscillateur 4, et les signaux issus de l'amplificateur de sortie 6, à savoir le signal de sortie sécuritaire S proprement dit, le signal de relecture et le signal d'auto-maintien.

Lorsque le dispositif de validation est à l'arrêt, c'est-à-dire dans son étal sécuritaire, les tensions v2 et v3 sont nulles, de sorte que les niveaux N3 et N4 sont au potentiel de N2.

Le processus d'initialisation d'un système équipé d'un tel dispositif peut alors se dérouler de la manière suivante :

Les microprocesseurs ou autres circuits des deux voies de traitement numérique procèdent de manière continue à l'examen des informations incidentes arrivant sur leurs entrées et aux auto-tests prévus. Les résultats numériques correspondants font l'objet d'une comparaison inter-voies au moyen d'échanges des résultats transcodés pour éviter la décalque accidentelle de l'un des résultats par l'autre. Si pour chaque voie, ces résultats sont corroborés par ceux de l'autre voie, alors il y a décision collégiale des microprocesseurs de procéder à l'armement du dispositif de validation.

A cet effet, un signal de commande d'armement C est émis pendant le temps nécessaire à la charge du condensateur C1 de la commande perdue CP3. On notera que ce signal de commande d'armement coupe simultanément le signal d'auto-maintien alimentant la commande perdue CP4, par l'intermédiaire de la porte ET, pour le cas où il s'agirait d'une impulsion parasite alors que le dispositif de validation se trouverait au travail, c'est-à-dire à l'état "1".

Les microprocesseurs des deux voies sont organisés pour faire coïncider le début de l'émission série des deux messages numériques A et B avec la chute du signal d'armement C, à l'instant t1. A cet instant, la chute du signal C fait passer la sortie de l'inverseur INV3 au potentiel de N2, d'où il s'ensuit que l'énergie de CP3 acquise pendant la commande d'armement se trouve transférée sur le niveau N3. La tension v2 se trouve ainsi constituée, de sorte que l'oscillateur 4 peut commencer à fonctionner, à l'instant t2, dans la mesure où les deux messages A et B sont bien présents et complémentaires.

Les premières transitions des messages A et B établissent progressivement la tension v3 comprise entre les niveaux N3 et N4, par l'intermédiaire des commandes perdues CP1 et CP2 et de la porte OU1, comme illustré sur la figure 6. Le relais statique 5 se trouve ainsi alimenté et peut alors commander le fonctionnement de l'amplificateur de sortie 6.

Au bout d'un temps t3-t1 représentant le délai nécessaire à l'établissement de la tension v3, le signal d'auto-maintien apparaît à la sortie de l'amplificateur 6, de même que le signal de relecture destiné aux voies de traitement numérique et le signal sécuritaire S destiné aux actionneurs, comme illustré sur la figure 8. On notera que tous ces signaux sont des signaux alternatifs tout ou rien.

L'énergie initiale apportée par la commande perdue CP3 n'est alors plus nécessaire et c'est l'énergie apportée par le signal d'auto-maintien, grâce à la commande perdue CP4, qui prend le relais.

Si maintenant le signal d'auto-maintien s'interrompt pendant un temps incompatible avec θ2 et θ3, les niveaux N3 et N4 s'effondrent et l'ensemble du dispositif de validation s'arrête de manière irréversible, par suite de l'annulation des tensions d'alimentation v2 et v3, ce qui constitué réellement une mémoire de défaut absolue.

Le dispositif de validation de messages numérique qui vient d'être décrit s'applique évidemment de manière particulièrement avantageuse aux systèmes de pilotage automatique des trains et de contrôle de leurs déplacements, mais il peut également s'appliquer, d'une manière générale, à tout domaine industriel dans lequel on doit fournir un signal de sécurité tout ou rien à partir de la détection d'un signal d'entrée, par exemple pour arrêter en sécurité une machine ou un processus industriel.

On notera en outre qu'un tel dispositif peut être réalisé sur une très petite surface de circuit imprimé. A titre d'exemple, dans une réalisation pratique utilisant la technique des circuits hybrides, on a pu loger l'ensemble du dispositif sur une surface ne dépassant pas 3cm$^2$.

### Revendications

1. Dispositif de validation de messages numériques, du type dans lequel on contrôle l'identité absolue et l'état dynamique de deux messages numériques (A et B) issus de deux voies de traitement en parallèle, avant d'élaborer, au moyen d'un amplificateur de sortie (6), un signal analogique tout ou rien de sécurité (S) assurant le fonctionnement d'un actionneur, ledit dispositif de validation comprenant en outre un pont de Wheatstone à diodes (1), **caractérisé en ce que** les entrées alternatives (2 et 3) dudit pont de Wheatstone sont alimentées respectivement par les deux messages (A, B), préalablement inversés l'un par rapport à l'autre, et dont la diagonale continue comporte un oscillateur (4) dont la sortie (s) constitue le signal de contrôle d'identité des messages (A, B), ce signal commandant l'amplificateur de sortie (6) par l'intermédiaire d'un relais statique (5).

2. Dispositif selon la revendication 1, **caractérisé en ce qu'**il comprend en outre deux pompes à diodes (CP1, CP2) alimentées respectivement par les deux messages numériques (A, B) et fonctionnant sur les transitions des changements d'état des messages, ces deux pompes à diodes (CP1, CP2) fournissant, par l'intermédiaire d'une porte OU (OU1), la tension (v3) nécessaire à l'alimentation du relais statique (5).

3. Dispositif selon la revendication 2, **caractérisé en ce qu'**il comprend en outre un système d'armement comportant deux autres pompes à diodes (CP3, CP4), l'une (CP3) alimentée par un signal de commande d'armement (C) issu des voies de traitement numérique et l'autre (CP4) par un signal d'auto-maintien issu de l'amplificateur de sortie (6), ces deux pompes à diodes (CP3, CP4) fournissant, par l'intermédiaire d'une porte OU (OU2), la tension d'alimentation (v2) nécessaire au fonctionnement de l'oscillateur (4).

4. Dispositif selon l'une quelconque des revendications 1 3, **caractérisé en ce que** l'oscillateur (4) du pont de Wheatstone (1) est pourvu d'une temporisation à la chute (θ1).

5. Dispositif selon le revendication 2, **caractérisé en ce que** les deux premières pompes à diodes (CP1, CP2) sont connectées aux entrées alternatives (2, 3) du pont de Wheatstone (1).

6. Dispositif selon l'une quelconque des revendications 2 à 5, **caractérisé en ce que** les deux messages numériques (A, B) sont appliqués au pont Wheatstone (1) par l'intermédiaire de coupleurs photo-électriques (PH1, PH2).

7. Dispositif selon l'une quelconque des revendications 2 à 6, **caractérisé en ce qu'**un premier coupleur photo-électrique (PH4) est inséré entre l'oscillateur (4) et le relais statique (5) et un second coupleur photo-électrique (PHS) est inséré entre le relais statique (5) et l'amplificateur de sortie (6).

8. Dispositif selon la revendication 3, **caractérisé en ce que** le signal de commande d'armement (C) est appliqué à la pompe à diode correspondante (CP3) par l'intermédiaire d'un coupleur photo-électrique (PH3).

9. Dispositif selon la revendication 3 ou 8, **caractérisé en ce qu'**une temporisation à la chute (θ2) est prévue sur la tension d'alimentation (v2) de l'oscillateur (4).

10. Dispositif selon l'une quelconque des revendications 2 à 9, **caractérisé en ce qu'**une temporisation à la chute (θ3) est prévue sur la tension d'alimentation (v3) du relais statique (5).

### Claims

1. Device for validating digital messages, of the type in which the absolute identity and the dynamic state of two digital messages (A and B) from two processing channels in parallel are checked before producing, by means of an output amplifier (6), and on/off analogue safety signal (S) ensuring the operation of an actuator, said device for validating further including a Wheatstone diode bridge (1), **characterized in that** the alternate inputs (2 and 3) of which said Wheatstone bridge are supplied, respectively with the two messages (A, B) previously inverted in relation to one another, and the continuous diagonal thereof comprises an oscillator (4) the output (s) of which constitutes the identity checking signal for the messages (A, B) this signal controlling the output amplifier (6) via a static relay (5).

2. Device according to claim 1, **characterized in that** it further includes two diode pumps (CP1, CP2) supplied respectively with the two digital messages (A, B) and operating on transitions of changes of state of the messages, these two diode pumps (CP1, CP2) providing, via an OR gate (OU 1), the voltage (v3) necessary to supply the static relay (5).

3. Device according to claim 2, **characterized in that** it further includes an arming system comprising two other diode pumps (CP3, CP4), one (CP3) supplied with an arming command signal (C) from the digital processing channels, and the other (CP4) supplied with a self-maintaining signal from the output amplifier (6), these two diode pumps (CP3, CP4) providing, via an OR gate (OU 2), the supply voltage (v2) necessary for the operation of the oscillator (4).

4. Device according to any one of claims 1 to 3, **characterized in that** the oscillator (4) of the Wheatstone bridge (1) is provided with a fall time delay device (θ 1).

5. Device according to claim 2, **characterized in that** the first two diode pumps (CP1, CP2) are connected to the alternate inputs (2, 3) of the Wheatstone bridge (1).

6. Device according to any one of claims 2 to 5, **characterized in that** the two digital messages (A, B) are applied to the Wheatstone bridge (1) via photoelectric couplers (PH1, PH2).

7. Device according to any one of claims 2 to 6, **characterized in that** a first photoelectric coupler (PH4) is inserted between the oscillator (4) and the static relay (5) and a second photoelectric coupler (PH5) is inserted between the static relay (5) and the output amplifier (6).

8. Device according to claim 3, **characterized in that** the arming command signal (C) is applied to the corresponding diode pump (CP3) via a photoelectric coupler (PH3).

9. Device according to claim 3 or 8, **characterized in that** a fall time delay device (θ 2) is provided on the supply voltage (v2) of the oscillator (4).

10. Device according to any one of claims 2 to 9, **characterized in that** a fall time delay device (θ 3) is provided on the supply voltage (v3) of the static relay (5).

**Patentansprüche**

1. Vorrichtung zur Freigabe von numerischen Botschaften des Typs, in der man die absolute Identität und den dynamischen Zustand von zwei numerischen Botschaften (A und B) überprüft, die aus zwei parallelen Verarbeitungswegen/-kanälen hervorgegangen sind, bevor mit Hilfe eines Leistungsverstärkers (6) ein analogisches Hilfs-Sicherheitssignal (S) (*) bearbeitet wird, das die Funktion eines Betätigungsgeräts gewährleistet, wobei die Freigabevorrichtung darüber hinaus eine Wheatstone-Diodenbrücke (1) beinhaltet, **dadurch gekennzeichnet, dass** die Alternativeingänge (2 und 3) der besagten Wheatstone-Diodenbrücke von den beiden Botschaften (A, B) entsprechend gespeist und zuvor eine im Verhältnis zur zweiten umgekehrt/umgepolt wurde und deren kontinuierliche Diode einen Oszillator (4) beinhaltet, dessen Ausgang (s) das Indentitätsüberprüfungssignal der Botschaften (A, B) bildet, wobei dieses Signal den Leistungsverstärker (6) mit Hilfe eines Statikrelais (5) betätigt.

2. Vorrichtung gemäß Patentanspruch 1, **dadurch gekennzeichnet, dass** sie darüber hinaus zwei Diodenpumpen (CP1, CP2) beinhaltet, die von den beiden numerischen Botschaften (A, B) entsprechend gespeist werden und auf die Übergänge der Zustandsänderungen der Botschaften ansprechen, wobei diese beiden Diodenpumpen (CP1, CP2) mit Hilfe eines ODER-Glieds (OU1) die Spannung (v3) liefern, die für die Speisung des Statikrelais (5) erforderlich ist.

3. Vorrichtung gemäß Patentanspruch 2, **dadurch gekennzeichnet, dass** sie darüber hinaus ein Anzugssystem beinhaltet, das zwei andere Diodenpumpen (CP3, CP4) umfasst, wobei die eine (CP3) von einem Anzugssteuersignal (C), das von den numerischen Verarbeitungswegen/kanälen ausgegeben wurde, und die andere (CP4) von einem selbsterhaltenden Signal gespeist wird, das von dem Leistungsverstärker (6) ausgegeben wurde, wobei diese beiden Diodenpumpen (CP3, CP4) die Zuführungsspannung (v2) mit Hilfe eines ODER-Glieds (OU2) liefern, die für das Funktionieren des Oszillators (4) erforderlich ist.

4. Vorrichtung gemäß irgendeinem der Patentansprüche 1 bis 3, **dadurch gekennzeichnet, dass** der Oszillator (4) der Wheatstone-Brücke (1) für eine Verzögerung des Abfalls (θ1) vorgesehen ist.

5. Vorrichtung gemäß des Patentanspruchs 2, **dadurch gekennzeichnet, dass** die beiden ersten Diodenpumpen (CP1, CP2) mit den Alternativeingängen (2, 3) der Wheatstone-Brücke (1) verbunden sind.

6. Vorrichtung gemäß irgendeinem der Patentansprüche 2 bis 5, **dadurch gekennzeichnet, dass** die beiden numerischen Botschaften (A, B) mit Hilfe von fotoelektrischen Kopplern (PH1, PH2) an der Wheatstone-Brücke (1) angelegt sind/zur Anwendung kommen.

7.  Vorrichtung gemäß irgendeinem der Patentansprüche 2. bis 6, **dadurch gekennzeichnet, dass** ein erster fotoelektrischer Koppler (PH4) zwischen dem Oszillator (4) und dem Statikrelais (5) und ein zweiter fotoelektrischer Koppler (PH5) zwischen dem Statikrelais (5) und dem Leistungsverstärker (6) zwischengeschaltet ist.

8.  Vorrichtung gemäß des Patentanspruchs 3, **dadurch gekennzeichnet, dass** das Anzugssteuersignal (C) mit Hilfe eines fotoelektrischen Kopplers (PH3) an die/der entsprechende/n Diodenpumpe (CP3) angelegt ist/zur Anwendung kommt.

9.  Vorrichtung gemäß des Patentanspruchs 3 oder 8, **dadurch gekennzeichnet, dass** eine Verzögerung des Abfalls (θ2) bei der Zuführungsspannung (v2) des Oszillators (4) vorgesehen ist.

10. Vorrichtung gemäß irgendeinem der Patentansprüche 2 bis 9, **dadurch gekennzeichnet, dass** eine Verzögerung des Abfalls (θ3) bei der Zuführungsspannung (v3) des Statikrelais (5) vorgesehen ist.

$$S = X\bar{Y} + \bar{X}Y$$

FIG.1

FIG.2

FIG.3

9

FIG.4

FIG.5

FIG.6

FIG.7

FIG.8